**Europäisches Patentamt**

**European Patent Office**

**Office européen des brevets**

(19)

(11) **EP 1 100 197 A2**

(12) **EUROPÄISCHE PATENTANMELDUNG**

(43) Veröffentlichungstag:
**16.05.2001 Patentblatt 2001/20**

(51) Int Cl.⁷: **H03H 21/00**

(21) Anmeldenummer: **00124541.4**

(22) Anmeldetag: **09.11.2000**

(84) Benannte Vertragsstaaten:
**AT BE CH CY DE DK ES FI FR GB GR IE IT LI LU MC NL PT SE TR**
Benannte Erstreckungsstaaten:
**AL LT LV MK RO SI**

(30) Priorität: **10.11.1999 DE 19954088**

(71) Anmelder: **SIEMENS AKTIENGESELLSCHAFT**
**80333 München (DE)**

(72) Erfinder: **Kraker, Alfred**
**1030 Wien (AT)**

(54) **Verfahren zur Filterung einer digitalen Signalfolge**

(57)    Es wird ein Verfahren zur Filterung einer digitalen Signalfolge mittels adaptiver Filter unter Zuhilfenahme der diskreten Parameter Wavelet Transformation angegeben, welches unter anderem in der Telekommunikationstechnik zur Echokompensation eingesetzt werden kann. Das erfindungsgemäße Verfahren zeichnet sich durch besonders geringe Filterlängen und somit wesentlich geringerem Rechenaufwand zur Feststellung des optimalen Koeffizientensatzes für die verwendeten Filter aus.

**MRA1**

$$d_n^1(x), d_n^2(x), ..., d_n^L(x) \quad c_n^L(x)$$

**MRA2**

$$d_n^1(r), d_n^2(r), ..., d_n^L(r) \quad c_n^L(r)$$

**AFI**

$$d_n^1(y), d_n^2(y), ..., d_n^L(y) \quad c_n^L(y)$$

**MSR**

$y(n-p)$

Fig. 1

**EP 1 100 197 A2**

**Beschreibung**

Die Erfindung betrifft ein Verfahren bei dem aus einer digitalen Eingangssignalfolge und einer Referenzfolge mittels adaptiver Filter eine Ausgangssignalfolge gebildet wird, wobei mit Hilfe der adaptiven Filter aus je einem Filtereingangssignal und je einem Filterreferenzsignal je ein Filterausgangssignal gebildet wird, welches möglichst optimal an das jeweilige Filterreferenzsignal angepaßt wird.

Derartige Verfahren werden beispielsweise in der Telekommunikationstechnik zur Echokompensation, die bei vergleichsweise großen zu überbrückenden Distanzen zwischen zwei Telekommunikationsendgeräten notwendig ist, eingesetzt. Dabei wird das bei der Empfangseinrichtung eintreffende Eingangssignal sowohl der unter dem Begriff "Hybrid" bekannten Einrichtung, welche das einlangende Signal in die lokale Schleife der Empfangseinrichtung und das abgehende Signal in die Leitung einspeist, als auch dem Eingang eines adaptiven Filters in der Empfangseinrichtung zugeführt. Das Ausgangssignal des adaptiven Filters wird von dem in die Leitung eingespeisten abgehenden Signal - in diesem Falle gleichzeitig das Referenzsignal - subtrahiert, wobei die verbleibende Differenz, also das Fehlersignal, zur Adaption der Koeffizienten des adaptiven Filters herangezogen wird.

Nach dem Stand der Technik wird dazu ein einziges Finite Input Response Filter, kurz FIR-Filter, mit einer der auftretenden Signalverzögerung angepaßten Koeffizientenanzahl eingesetzt. Bei einer Abtastrate von 8 kHz sind dazu einige hundert Koeffizienten nötig, wobei die unter dem Namen "Least Squares Wiener-Hopf" bekannte Gleichung den optimalen Koeffizientensatz für ein solches Filter liefert. Da übliche Signalprozessoren jedoch über beschränkte Rechenleistung verfügen, wird anstelle der mathematisch optimalen "Least Squares Wiener-Hopf"-Gleichung nur das Gradienten-Verfahren angewendet, welches weniger Rechenaufwand erfordert. Dieses Verfahren bedingt jedoch lange Lernzeiten und ist nicht geeignet zu jedem Eingangswert ein optimales Ergebnis zu liefern.

Des weiteren weisen die damit bestimmten Filter wegen der Berücksichtigung der auftretenden Signalverzögerung wesentlich mehr Koeffizienten auf, als es zur Approximation des Betragsfrequenzganges nötig wäre, sind also überbestimmt, und neigen daher zu instabilem Verhalten.

Aus der US 5,657,349 vom 12. August 1997 "Method and apparatus capable of quickly identifying a unknown system with a final error reduced" ist es weiterhin bekannt, dass ein unbekanntes System mittels K adaptiver Filter identifiziert werden kann, wobei K eine Ganzzahl größer 1 ist. Dabei wird an das unbekannte System ein Eingangssignal angelegt, dieses Eingangssignal mit Hilfe einer Analysefilterbank in K Subbandsignale unterteilt. Jedes dieser K Subbandsignale wird anschließend unterabgetastet und als Filtereingangssignal an je eines der K adaptiven Filter angelegt. Ebenso wie das Eingangsignal wird das Ausgangssignal des unbekannten Systems in K Subbandsignale unterteilt, jedes dieser K Subbandsignale unterabgetastet und als Filterreferenzsignal an je eines der K adaptiven Filter angelegt. Jedes der K adaptiven Filter berechnet die Differenz aus Filterreferenz- und Filtereingangsignal und gibt diese als Filterausgangssignal aus, wobei dieses auch zur Adaption des Filterkoeffizienten herangezogen wird. Die Filterausgangsignale werden anschließend überabgetastet und mittels einer Synthesefilterbank zu einem Ausgangsignal zusammengesetzt.

Wird nun für das Eingangssignal ein Pseudoecho und als Ausgangssignal des unbekannten Systems ein mit einem Echo behaftetes Nutzsignal vorgesehen, so liegt am Ausgang der Synthesefilterbank ein echounterdrücktes Nutzsignal vor. Das Maß der Echounterdrückung hängt dabei wesentlich von den Koeffizienten der adaptiven Filter ab.

Die Qualität des Ausgangsignals hängt aber auch von der Teilung des gesamten Frequenzspektrums in Subbänder ab, wobei eine feinere Unterteilung ein qualitätsmäßig besseres Signal liefert. Da die Unterteilung in gleich breite Frequenzbänder erfolgt, steht einer relativ geringen Qualitätsverbesserung ein technisch und rechnerisch vergleichsweise hoher Aufwand gegenüber.

Der Erfindung liegt also die Aufgabe zugrunde, ein Verfahren zur Filterung einer digitalen Signalfolge anzugeben, bei dem die Filterung mit vergleichsweise geringem technischen und rechnerischem Aufwand erfolgt.

Dies geschieht erfindungsgemäß mit einem Verfahren nach Anspruch 1.

Damit ist eine Alternative zu herkömmlichen Verfahren gegeben, bei der für die Approximation des Betragsfrequenzganges und für die Berücksichtigung der Signalverzögerung keine gegensätzlichen Forderungen zu erfüllen sind. Diese zeichnet sich durch besonders geringe Filterlängen - also durch wenige Koeffizienten - und somit wesentlich geringerem Rechenaufwand zur Feststellung des optimalen Koeffizientensatzes für die verwendeten Filter auszeichnet.

Eine weitere vorteilhafte Ausgestaltung des erfindungsgemäßen Verfahrens sieht vor, daß anstatt der Ausgangssignalfolge $y(n\text{-}p)$ die Ausgangssignalfolge $\varepsilon(n\text{-}p)$ rekonstruiert wird und zwar aus den Fehlerfolgen $d_n^1(\varepsilon), d_n^2(\varepsilon),...,d_n^L(\varepsilon)$ und $c_n^L(\varepsilon)$. Dieses Verfahren wird beispielsweise für die unter dem Begriff "Interference Canceling" bekannte Anwendung eingesetzt. Dabei wird den adaptiven Filtern ein verrauschtes Nutzsignal als Filterreferenzsignal und ein dazu korreliertes Rauschen als Filtereingangssignal zugeführt. Da die adaptiven Filter dazu ausgelegt sind, das Filterausgangssignal dem Filterreferenzsignal anzupassen, liegt als Filterausgangssignal das Rauschen, als Fehlersignal das nahezu unverrauschte Nutzsignal vor.

Eine vorteilhafte Ausgestaltung des erfindungsgemäßen Verfahrens sieht vor, daß die Komponenten $d_n^1(x),$

$d_n^2(x),...,d_n^L(x)$ und $c_n^L(x)$, beziehungsweise $d_n^1(r),d_n^2(r),...,d_n^L(r)$ und $c_n^L(r)$ der diskreten Parameter Wavelet Transformation nach dem Mallat Algorithmus für die Multi Resolution Analysis ermittelt werden und die Ausgangssignalfolge $y(n-p)$ beziehungsweise $\varepsilon(n-p)$ mittels der dazu inversen Operation, dem Mallat Algorithmus für die Multi Stage Synthesis, aus den Bestandteilen $d_n^1(y),d_n^2(y),...,d_n^L(y)$ und $c_n^L(y)$ rekonstruiert wird. Der Mallat Algorithmus für die Multi Resolution Analysis, der in "Mallat, S.G.; A theory for Multiresolution Signal Decomp.: The Wavelet Representation; IEEE Trans. Pattern Analysis, Machine Intelligence, Vol. 11, No7, pp. 674-693, July 1989" beschrieben wird, bietet eine Methode, die diskrete Parameter Wavelet Transformation, kurz DPWT, der praktischen Anwendung mittels Digitaler Signalprozessoren mit vergleichsweise geringem technischen Aufwand zugänglich zu machen. Hierfür sind Module nötig, die aus einer Finite Impulse Response Tiefpaßfilterung (FIR- Tiefpaßfilterung) und direkt darauf folgender Unterabtastung um den Faktor zwei bestehen und Module, die aus einer Finite Impulse Response Hochpaßfilterung (FIR- Hochpaßfilterung) und direkt darauf folgender Unterabtastung um den Faktor zwei bestehen. Für den Mallat Algorithmus für die Multi Stage Synthesis, der in "Chan, Y. T.; Wavelet Basics; Kluwer Academic Publ. Group 1995" beschrieben ist, sind Module nötig, die aus einer Überabtastung um den Faktor zwei und direkt darauf folgender FIR-Tiefpaßfilterung bestehen und Module, die aus einer Überabtastung um den Faktor zwei und direkt darauf folgender FIR-Hochpaßfilterung bestehen. Die Absolutwerte der Koeffizienten aller verwendeter Tiefpaß- und Hochpaßfilter sind jeweils identisch. Zwischen den verschiedenen Filterarten treten lediglich Unterschiede in der Reihung und dem Vorzeichen der jeweiligen Absolutwerte der Koeffizientensätze auf, sodaß ein gemeinsamer Koeffizientensatz für alle Filter verwendet und somit Speicherplatz eingespart werden kann.

Darüber hinaus ergibt sich aufgrund der rekursiven Unterabtastung um den Faktor zwei zwischen den einzelnen Stufen auch schon bei einer Filterlänge, welche auf die Approximation des Betragsfrequenzganges abgestimmt ist, eine vergleichsweise hohe mögliche Signalverzögerung. Besonders vorteilhaft ist dabei, daß die Anzahl der erforderlichen Rechenschritte, die sich zu

$$n = n_0 + \frac{n_0}{2} + \frac{n_0}{4} + ... = 2 \cdot n_0$$

berechnet, wenn $n_0$ die Anzahl der Rechenschritte in der ersten Stufe bezeichnet, im Vergleich zu einem einzigen langen FIR-Filters wesentlich geringer ist. Die angeführte Formel gilt unter der für das erfindungsgemäße Verfahren nicht notwendigen Voraussetzung, daß alle Filter gleiche Länge haben.

Weiterhin ist es günstig, wenn die Koeffizienten der im Rahmen des Mallat Algorithmus für die Multi Resolution Analysis und die Multi Stage Synthesis eingesetzten FIR-Filter $g(l),h(l),\bar{g}(l),\bar{h}(l)$ $l$ = 0,1,...,$p$-1 mit den von I. Daubechies definierten Werten übereinstimmen, wobei $p$-1 die Filterordnung angibt. Diese Klasse von Wavelets, die aus "Daubechies, I.; Orthonormal Basis of Compactly Supported Wavelets; Comm.in Pure and Applied Math., Vol. 41, No. 7, pp. 909-996, 1988" bekannt ist, bietet gute Auflösung sowohl im Zeit- als auch im Frequenzbereich. Die Wavelets sind überdies zeitlich exakt und im Frequenzbereich durch ein rasch abfallendes Spektrum bei tiefen und hohen Frequenzen beschränkt.

Eine vorteilhafte Ausgestaltung der Erfindung sieht für die Arbeitsweise der adaptiven Filter den Least Mean Sqare Algorithmus vor. Dieser Algorithmus liefert den optimalen Koeffizientensatz für ein FIR-Filter.

Die Erfindung wird anhand eines in den Figuren dargestellten Ausführungsbeispiels näher erläutert, welches ein beispielhaftes Verfahren zur adaptiven Filterung betrifft, das unter anderem zur Echokompensation auf dem Gebiet der Telekommunikationstechnik eingesetzt werden kann, insbesondere wenn anstatt des Ausgangssignals $y(n-p)$ das Fehlersignal $\varepsilon(n-p)$ rekonstruiert wird. Es zeigen:

Figur 1: die Grobstruktur des erfindungsgemäßen Verfahrens;
Figur 2: die Aufspaltung des Eingangssignales $x(n)$ in die Komponenten der diskreten Parameter Wavelet Transformation;
Figur 3: die Aufspaltung der Referenzfolge $r(n)$ analog zu Figur 2;
Figur 4: die Adaptive Filterung der Anteile der diskreten Parameter Wavelet Transformation und
Figur 5: die inverse diskrete Parameter Wavelet Transformation, angewandt auf die Komponenten $d_n^0(y),d_n^1(y),...,$ $d_n^L(y)$ und $c_n^L(y)$.

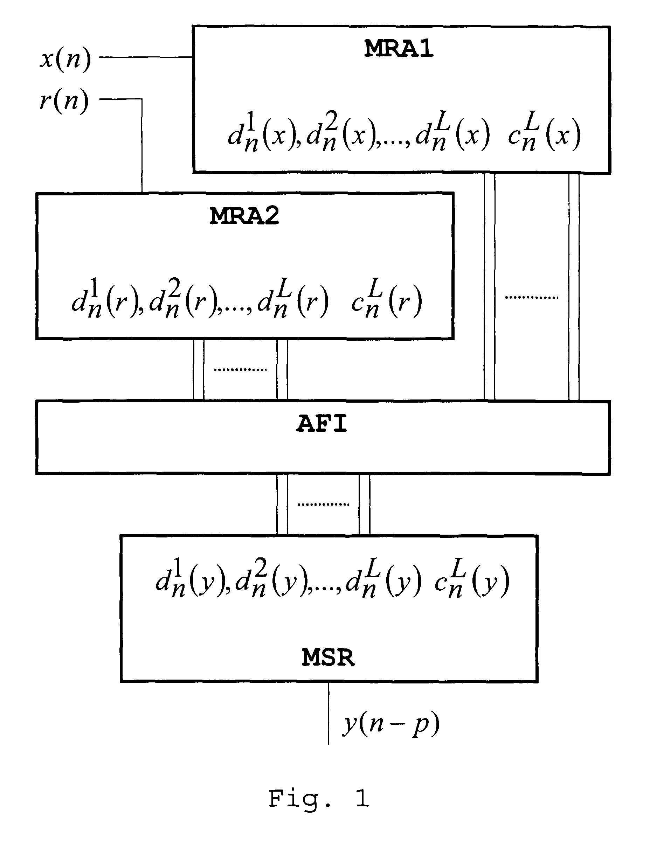

Figur 1 zeigt eine digitale Eingangssignalfolge $x(n)$, welche ein mit der Abtastfrequenz 8 kHz abgetastetes Analogsignal darstellt. Aus diesem werden mit Hilfe eines ersten Multi Resolution Analysis Moduls MRA1, das die Durchführung des Mallat Algorithmus für die Multi Resolution Analysis ermöglicht, die Komponenten $d_n^1(x),d_n^2(x),...,d_n^L(x)$ und $c_n^L(x)$ der diskreten Parameter Wavelet Transformation ermittelt. Analog dazu werden aus einer Referenzfolge $r(n)$ unter Zuhilfenahme eines zweiten Multi Resolution Analysis Moduls MRA2 die Anteile $d_n^1(r),d_n^2(r),...,d_n^L(r)$ und $c_n^L(r)$ errechnet. Die Komponenten $d_n^1(x),d_n^2(x),...,d_n^L(x)$ und $c_n^L(x)$ dienen dabei als Filtereingangssignale, die Komponen-

ten $d_n^1(r), d_n^2(r),...,d_n^L(r)$ und $c_n^L(r)$ als Filterreferenzsignale für ein adaptives Filtermodul AFI mittels dem die adaptive Filterung vorgenommen wird. Die Filterausgangssignale $d_n^1(y), d_n^2(y),...,d_n^L(y)$ und $c_n^L(y)$ werden mit Hilfe eines Multi Stage Recontruction Moduls MSR, das die Durchführung des Mallat Algorithmus für die Multi Stage Synthesis ermöglicht, der inversen diskreten Parameter Wavelet Transformation unterworfen, welche als Ergebnis die Ausgangssignalfolge $y(n\text{-}p)$ liefert.

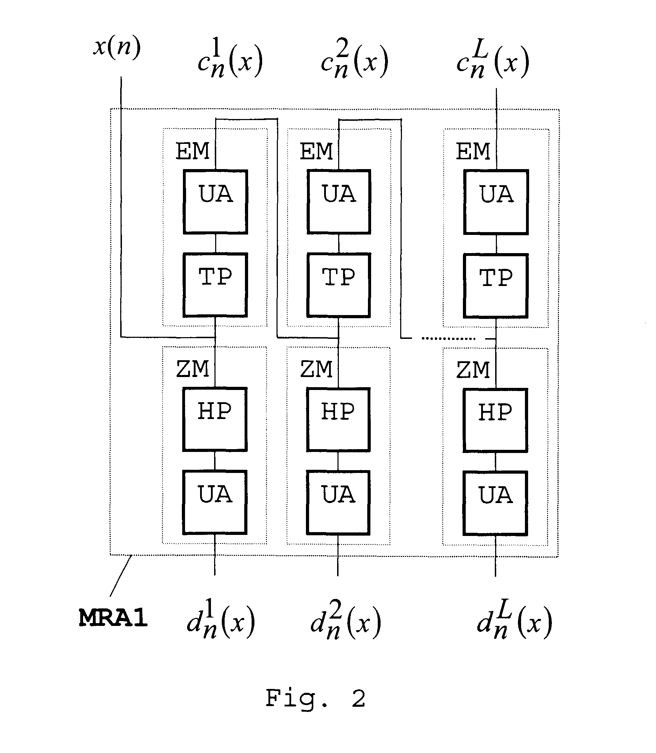

Aus Figur 2 ist ersichtlich, daß die Eingangssignalfolge $x(n)$ rekursiv mittels mehrerer gleichartiger, im Signalverlauf hintereinander geschalteter erster Module EM in die Ausgangssignale $c_n^1(x), c_n^2(x),...,c_n^L(x)$ aufgespalten wird.

In jedem ersten Modul EM erfolgt dabei eine FIR-Tiefpaßfilterung, und danach eine Unterabtastung UA um den Faktor zwei. Bei dieser Unterabtastung wird jeder zweite Zahlenwert der Signalfolge gestrichen und die Zahlenfolge neu indiziert. Die dadurch entstehende Abtastfrequenz ist daher geringer, als es für $x(n)$ durch das Shannon`sche Abtasttheorem vorgegeben wäre. Die Koeffizienten der FIR-Tiefpaßfilter entsprechen dabei $\sqrt{2} \cdot \bar{g}(l)$ $l = 0,1,..., p\text{-}1$.

Aus der Eingangssignalfolge $x(n)$ und den Ausgangssignalen $c_n^1(x), c_n^2(x),...,c_n^L(x)$ werden mittels mehrerer gleichartiger, zweiter Module ZM - in denen eine FIR-Hochpaßfilterung mit Koeffizienten entsprechend $\sqrt{2} \cdot \bar{h}(l)$ $l = 0,1,..., p\text{-}1$ und danach eine Unterabtastung UA um den Faktor zwei erfolgt - die Komponenten der diskreten Parameter Wavelet Transformation $d_n^1(x), d_n^2(x),...,d_n^L(x)$ gebildet.

Alle ersten und zweiten Module werden zu einem ersten Multi Resolution Analysis Modul MRA1 zusammengefaßt, wobei $x(n)$ ein Eingangssignal, $d_n^1(x), d_n^2(x),...,d_n^L(x)$ und $c_n^L(x)$ Ausgangssignale darstellen.

Der Vorteil des erfindungsgemäßen Verfahrens liegt nun darin, daß die Abtastfrequenz der Signalfolge der Komponenten $d_n^1(x), d_n^2(x),...,d_n^L(x)$ nur $1/2^1, 1/2^2,... \ 1/2^L$ des Wertes der Abtastfrequenz der Eingansgsignalfolge aufweist und damit auch der Berechnungsaufwand, bezogen auf ein Abtastintervall des Eingangssignales, gegenüber bekannten Verfahren entsprechend reduziert wird. Die Komponenten $c_n^1(x), c_n^2(x),...,c_n^{L\text{-}1}(x)$ stellen lediglich Zwischenergebnisse dar und werden nicht weiterverarbeitet.

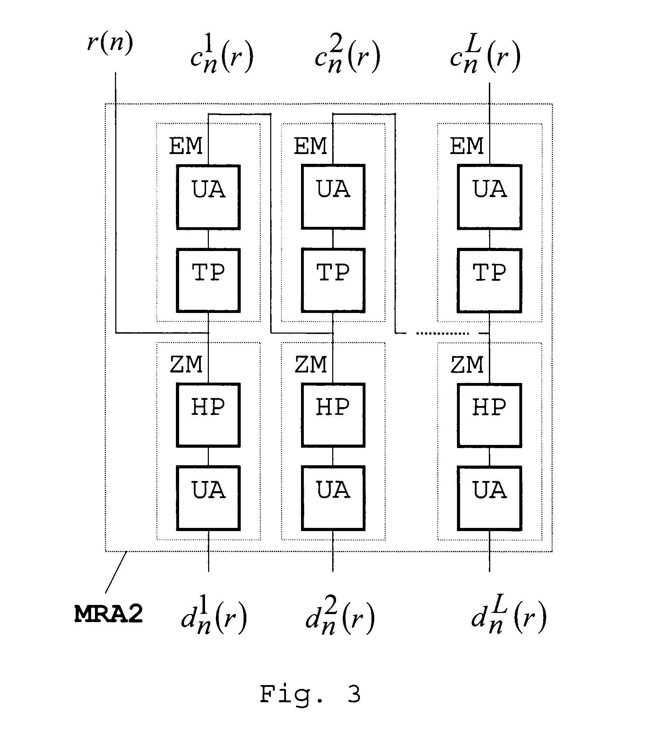

Figur 3 zeigt analog zu Figur 2 die Verarbeitung der Referenzfolge $r(n)$. Alle ersten und zweiten Module EM und ZM werden dabei zu einem zweiten Multi Resolution Analysis Modul MRA2 zusammengefaßt, wobei $r(n)$ ein Eingangssignal, $d_n^1(r), d_n^2(r),...,d_n^L(r)$ und $c_n^L(r)$ Ausgangssignale darstellen.

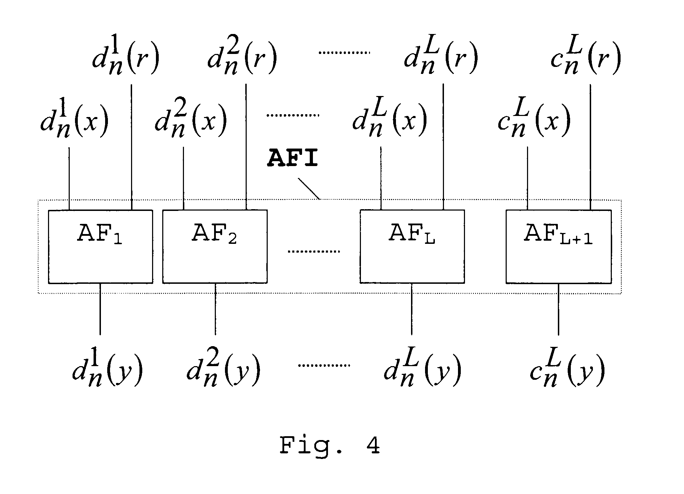

Aus Figur 4 kann ersehen werden, daß die Anteile $d_n^1(x), d_n^2(x),...,d_n^L(x)$ und $c_n^L(x)$, beziehungsweise $d_n^1(r), d_n^2(r),...,d_n^L(r)$ und $c_n^L(r)$ der diskreten Parameter Wavelet Transformation paarweise je ein Filtereingangs- und ein Filterreferenzsignal adaptiver Filter $AF_1$ bis $AF_{L+1}$ bilden. Die Komponenten $d_n^1(y), d_n^2(y),...,d_n^L(y)$ und $c_n^L(y)$ stellen die Filterausgangssignale der adaptiven Filter $AF_1$ bis $AF_{L+1}$ dar, wobei letztere zu einem adaptiven Filtermodul AFI zusammengefaßt werden.

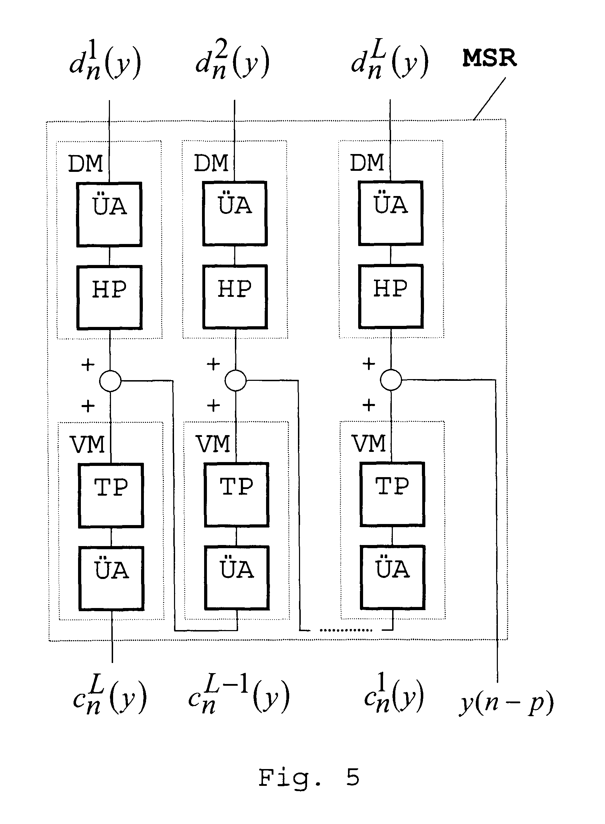

Figur 5 zeigt, daß die Komponenten $d_n^1(y), d_n^2(y),...,d_n^L(y)$ jeweils ein Eingangssignal von je einem dritten Modul DM bilden, in dem eine Überabtastung ÜA um den Faktor zwei, und danach eine FIR-Hochpaßfilterung erfolgt. Bei dieser Überabtastung wird zwischen jedem zweiten Zahlenwert der Signalfolge der Wert Null eingefügt und die Zahlenfolge neu indiziert. Die dadurch entstehende Abtastfrequenz am Ausgang des dritten Moduls ist daher doppelt so groß, wie die Abtastfrequenz am Eingang des Moduls. Die Koeffizienten der FIR-Hochpaßfilter entsprechen dabei $\sqrt{2} \cdot h(l)$ $l = 0,1,..., p\text{-}1$.

Die Anteile $c_n^L(y), c_n^{L\text{-}1}(y),...,c_n^1(y)$ sind analog dazu die Eingangssignale mehrerer gleichartiger, vierter Module VM, in denen eine Überabtastung ÜA um den Faktor 2 und danach eine FIR-Tiefpaßfilterung mit Koeffizienten entsprechend $\sqrt{2} \cdot g(l)$ erfolgt.

Die Ausgangssignale der dritten und vierten Module DM und VM werden paarweise in folgender Weise summiert:

Die Summe des Ausgangssignales des dritten Moduls DM mit dem Eingangssignal $d_n^1(y)$ und des Ausgangssignals des vierten Moduls VM mit dem Eingangssignal $c_n^L(y)$ bildet zugleich den Anteil $c_n^{L\text{-}1}(y)$. Diese Vorschrift wird rekursiv solange angewandt, bis die Komponente $c_n^0(y)$ erreicht wird, die mit der Ausgangssignalfolge $y(n\text{-}p)$ identisch ist.

Alle dritten und vierten Module werden zu einem Multi Stage Reconstruction Modul MSR zusammengefaßt, wobei $d_n^1(y), d_n^2(y),...,d_n^L(y)$ und $c_n^L(y)$ Eingangssignale, $y(n\text{-}p)$ ein Ausgangssignal darstellen.

**Patentansprüche**

1. Verfahren bei dem aus einer digitalen Eingangssignalfolge $x(n)$ und einer Referenzfolge $r(n)$ mittels adaptiver Filter eine Ausgangssignalfolge y(n-p) gebildet wird, wobei mit Hilfe der adaptiven Filter aus je einem Filtereingangssignal und je einem Filterreferenzsignal je ein Filterausgangssignal gebildet wird, welches möglichst optimal an das jeweilige Filterreferenzsignal angepaßt wird,

   **dadurch gekennzeichnet,**

   - dass aus der digitalen Eingangssignalfolge $x(n)$ und der digitalen Referenzfolge $r(n)$ mittels Skalierungsfunktion

$$\phi(t) = 2 \cdot \sum_{l=0}^{p-1} g(l) \cdot \phi(2 \cdot t - l)$$

die Zeitfunktionen

$$x^0(t) = \sum_n x(n) \cdot \phi(t-n) \quad \text{und} \quad r^0(t) = \sum_n r(n) \cdot \phi(t-n)$$

gebildet werden,

- daas daraus mittels Wavelet

$$\psi(t) = 2 \cdot \sum_{l=0}^{p-1} h(l) \cdot \phi(2 \cdot t - l)$$

die Anteile $d_n^1(x), d_n^2(x), \ldots, d_n^L(x)$ und $c_n^L(x)$, beziehungsweise $d_n^1(r), d_n^2(r), \ldots, d_n^L(r)$ und $c_n^L(r)$ der diskreten Parameter Wavelet Transformation ermittelt werden, welche paarweise jeweils als ein Filtereingangs- und als ein Filterreferenzsignal an L+1 adaptive Filter angelegt werden und

- dass die Filterausgangssignale der adaptiven Filter $d_n^1(y) d_n^2(y), \ldots, d_n^L(y)$ und $c_n^L(y)$ mittels der zur ursprünglich angewandten diskreten Parameter Wavelet Transformation inversen Operation zu einer einzigen Ausgangssignalfolge $y(n\text{-}p)$ zusammengesetzt werden, wobei gilt:

$$d_n^m(x) = DPWT(x,m,n)$$

$$d_n^m(r) = DPWT(r,m,n)$$

$$h(l) = (-1)^l \cdot g(p\text{-}1\text{-}l)$$

$$\bar{g}(l) = g(p\text{-}1\text{-}l)$$

$$\bar{h}(l) = (-1)^{l+1} \cdot g(l)$$

$$\bar{h}(l) = h(p\text{-}1\text{-}l)$$

$$\sum_{l=0}^{p-1} g^2(l) = \sum_{l=0}^{p-1} \bar{h}^2(l) = \frac{1}{2} \; ,$$

und

$$\sum_{l=0}^{p-1} g(l) \cdot g(l + 2 \cdot k) = \sum_{l=0}^{p-1} h(l) \cdot h(l + 2 \cdot k) = \begin{vmatrix} 0 \; f\ddot{u}r k = 1,2,\ldots, p-1 \\ \frac{1}{2} \; f\ddot{u}r k = 0 \end{vmatrix}$$

**2.** Verfahren bei dem aus einer digitalen Eingangssignalfolge $x(n)$ und einer Referenzfolge $r(n)$ mittels adaptiver Filter eine Ausgangssignalfolge $\varepsilon(n\text{-}p)$ gebildet wird, wobei mit Hilfe der adaptiven Filter aus je einem Filtereingangssignal und je einem Filterreferenzsignal je ein Filterausgangssignal gebildet wird, welches möglichst optimal an das jeweilige Filterreferenzsignal angepaßt wird,

**dadurch gekennzeichnet,**

- dass aus der digitalen Eingangssignalfolge $x(n)$ und der digitalen Referenzfolge $r(n)$ mittels Skalierungsfunktion

$$\phi(t) = 2 \cdot \sum_{l=0}^{p-1} g(l) \cdot \phi(2 \cdot t - l)$$

die Zeitfunktionen

$$x^0(t) = \sum_n x(n) \cdot \phi(t-n) \quad \text{und} \quad r^0(t) = \sum_n r(n) \cdot \phi(t-n)$$

gebildet werden,

- dass daraus mittels Wavelet

$$\psi(t) = 2 \cdot \sum_{l=0}^{p-1} h(l) \cdot \phi(2 \cdot t - l)$$

die Anteile $d_n^1(x), d_n^2(x), ..., d_n^L(x)$ und $c_n^L(x)$, beziehungsweise $d_n^1(r), d_n^2(r), ..., d_n^L(r)$ und $c_n^L(r)$ der diskreten Parameter Wavelet Transformation ermittelt werden, welche paarweise jeweils als ein Filtereingangs- und als ein Filterreferenzsignal an L+1 adaptive Filter angelegt werden,

- aus den Filterausgangssignalen der adaptiven Filter $d_n^1(y), d_n^2(y), ..., d_n^L(y)$ und $c_n^L(y)$ und den Anteilen $d_n^1(r), d_n^2(r), ..., d_n^L(r)$ und $c_n^L(r)$ paarweise die Differenzen $d_n^m(\varepsilon) = d_n^m(r) - d_n^m(y)$ und $c_n^L(\varepsilon) = c_n^L(r) - c_n^L(y)$ errechnet werden und

- dass die Komponenten der daraus resultierenden Fehlerfolge $d_n^1(\varepsilon), d_n^2(\varepsilon), ..., d_n^L(\varepsilon)$ und $c_n^L(\varepsilon)$ mittels der zur ursprünglich angewandten diskreten Parameter Wavelet Transformation inversen Operation zu einer einzigen Ausgangssignalfolge $\varepsilon(n\text{-}p)$ zusammengesetzt werden, wobei gilt:

$$d_n^m(x) = DPWT(x,m,n)$$

$$d_n^m(r) = DPWT(r,m,n)$$

$$h(l) = (-1)^l \cdot g(p\text{-}1\text{-}l)$$

$$\bar{g}(l) = g(p\text{-}1\text{-}l)$$

$$\bar{h}(l) = (-1)^{l+1} \cdot g(l)$$

$$\bar{h}(l) = h(p\text{-}1\text{-}l)$$

$$\sum_{l=0}^{p-1} g^2(l) = \sum_{l=0}^{p-1} h^2(l) = \frac{1}{2} \ ,$$

und

$$\sum_{l=0}^{p-1} g(l) \cdot g(l+2\cdot k) = \sum_{l=0}^{p-1} h(l) \cdot h(l+2\cdot k) = \begin{vmatrix} 0 \ f\ddot{u}r\, k = 1,2,...,p-1 \\ \dfrac{1}{2} \ f\ddot{u}r\, k = 0 \end{vmatrix}$$

3.  Verfahren nach Anspruch 1, **dadurch gekennzeich net**, daß die Komponenten $d_n^1(x), d_n^2(x),...,d_n^L(x)$ und $c_n^L(x)$, beziehungsweise $d_n^1(r), d_n^2(r),...,d_n^L(r)$ und $c_n^L(r)$ der diskreten Parameter Wavelet Transformation nach dem Mallat Algorithmus für die Multi Resolution Analysis ermittelt werden und die Ausgangssignalfolge *y(n-p)* mittels der dazu inversen Operation, dem Mallat Algorithmus für die Multi Stage Synthesis, aus den Bestandteilen $d_n^1(y), d_n^2(y),...,$ $d_n^L(y)$ und $c_n^L(y)$ rekonstruiert wird.

4.  Verfahren nach Anspruch 2, **dadurch gekennzeichnet**, daß die Komponenten $d_n^1(x), d_n^2(x),...,d_n^L(x)$ und $c_n^L(x)$, beziehungsweise $d_n^1(r) d_n^2(r),...,d_n^L(r)$ und $c_n^L(r)$ der diskreten Parameter Wavelet Transformation nach dem Mallat Algorithmus für die Multi Resolution Analysis ermittelt werden und die Ausgangssignalfolge $\varepsilon$*(n-p)* mittels der dazu inversen Operation, dem Mallat Algorithmus für die Multi Stage Synthesis, aus den Bestandteilen $d_n^1(\varepsilon), d_n^2(\varepsilon),...,$ $d_n^L(\varepsilon)$ und $c_n^L(\varepsilon)$ rekonstruiert wird.

5.  Verfahren nach einem der Ansprüche 3 bis 4, **dadurch gekennzeichnet**, daß die Koeffizienten $g(l), \bar{g}(l), h(l)$ und $\bar{h}(l)$ der im Rahmen des Mallat Algorithmus für die Multi Resolution Analysis und der dazu inversen Operation eingesetzten FIR-Filter mit den von I. Daubechies definierten Werten übereinstimmen.

6.  Verfahren nach einem der Ansprüche 1 bis 5, dadurch gekennzeichnet, daß für die Arbeitsweise der adaptiven Filter der Least Mean Sqare Algorithmus vorgesehen ist.

MRA1

$$d_n^1(x), d_n^2(x), ..., d_n^L(x) \quad c_n^L(x)$$

$x(n)$

$r(n)$

MRA2

$$d_n^1(r), d_n^2(r), ..., d_n^L(r) \quad c_n^L(r)$$

AFI

$$d_n^1(y), d_n^2(y), ..., d_n^L(y) \quad c_n^L(y)$$

MSR

$$y(n-p)$$

Fig. 1

$x(n)$  $c_n^1(x)$  $c_n^2(x)$  $c_n^L(x)$

EM    EM    EM

UA    UA    UA

TP    TP    TP

ZM    ZM    ZM

HP    HP    HP

UA    UA    UA

**MRA1**  $d_n^1(x)$  $d_n^2(x)$  $d_n^L(x)$

Fig. 2

$r(n)$　　$c_n^1(r)$　　$c_n^2(r)$　　$c_n^L(r)$

| EM | EM | EM |
|----|----|----|
| UA | UA | UA |
| TP | TP | TP |

| ZM | ZM | ZM |
|----|----|----|
| HP | HP | HP |
| UA | UA | UA |

MRA2　　$d_n^1(r)$　　$d_n^2(r)$　　$d_n^L(r)$

Fig. 3

$$d_n^1(r) \qquad d_n^2(r) \quad \cdots\cdots \quad d_n^L(r) \qquad c_n^L(r)$$

$$d_n^1(x) \qquad d_n^2(x) \quad \cdots\cdots \quad d_n^L(x) \qquad c_n^L(x)$$

**AFI**

| AF$_1$ | AF$_2$ | $\cdots\cdots$ | AF$_L$ | AF$_{L+1}$ |

$$d_n^1(y) \qquad d_n^2(y) \quad \cdots\cdots \quad d_n^L(y) \qquad c_n^L(y)$$

Fig. 4

Fig. 5